# EUROPÄISCHE PATENTSCHRIFT

(11) **EP 3 061 168 B1**
(45) Veröffentlichungstag und Bekanntmachung des Hinweises auf die Patenterteilung: **12.12.2018**
(21) Anmeldenummer: 14784481.5
(22) Anmeldetag: 16.10.2014
(51) Int. Cl.: H02B 1/052

(54) **TRAGSCHIENENGEHÄUSE**
SUPPORT RAIL ENCLOSURE
BOÎTIER SUR RAIL

(30) Priorität: 21.10.2013 DE 102013111551
(43) Veröffentlichungstag der Anmeldung: 31.08.2016
(73) Patentinhaber: Wago Verwaltungsgesellschaft mbH, 32423 Minden (DE)
(72) Erfinder: MICKMANN, Viktor, 33604 Bielefeld (DE)
(74) Vertreter: Gerstein, Hans Joachim
(86) Internationale Anmeldenummer: PCT/EP2014/072231
(87) Internationale Veröffentlichungsnummer: WO 2015/059027

(56) Entgegenhaltungen:
- EP-B1- 2 003 754
- WO-A1-2004/114466
- WO-A1-2013/054873

## Beschreibung

Die Erfindung geht aus von einem Tragschienengehäuse mit einem Rastfuß zum Aufsetzen auf eine Tragschiene, wobei der Rastfuß
- eine Tragschienenaufnahmeöffnung zur Aufnahme einer Tragschiene,
- zwei relativ zueinander bewegliche Rastlaschen mit jeweils mindestens einer Rastnase, die in einer Rastposition in die Tragschienenaufnahmeöffnung zur Verrastung mit einer in der Tragschienenaufnahmeöffnung aufnehmbaren Tragschiene hineinragen, und
- ein Koppelelement hat, das in Wirkverbindung mit den beiden Rastlaschen steht und eine Bewegung einer Rastlasche in eine Bewegung der anderen Rastlasche überträgt.

Derartige Tragschienengehäuse werden für elektronische Geräte vielfältiger Art genutzt, die auf einer Tragschiene nebeneinander aufgerastet werden, wobei die Tragschiene an einer Montagewand z.B. in einem Schaltschrank befestigt ist. Auf diese Weise kann eine geordnete Verdrahtung von elektrischen bzw. elektronischen Teilnehmern, wie beispielsweise Sensoren, Aktoren und sonstigen Geräten, erreicht werden. Derartige Tragschienengehäuse sind prinzipiell z.B. aus der DE 44 02 002 B4 für eine modulare Steuerungseinrichtung bekannt.

EP 0 437 124 B1 zeigt ein Tragschienengehäuse mit zwei relativ zueinander beweglichen Rastlaschen, deren Rastnasen eine Tragschiene untergreifen. Die Betätigung der Rastlaschen erfolgt durch Aufbringen einer Zugkraft auf eine der Rastlaschen. Die Rastlaschen können in einer offenen Position mit Hilfe eines federbelasteten Verriegelungsfingers fixiert werden, der auf die zugbetätigte Federlasche einwirkt.

EP 2 003 754 B1 offenbart ein modulares elektrisches Gerät mit einer Vorrichtung zum Festklemmen an einer Tragschiene. Es sind zwei zur Bewegung zwischen einer vorgerückten Stellung und einer eingefahrenen Stellung bewegbare Schieber mit einem Simultanbetätigungsmechanismus vorgesehen. Der Simultanbetätigungsmechanismus bewirkt bei Betätigung des ersten Schiebers auch eine Betätigung des zweiten Schiebers. Er hat ein elastisches Glied zum Schieben des zweiten Schiebers in die ausgefahrene Stellung und ein rotierendes Schiebeglied zur Rotation um eine Drehachse und Ausübung einer dem elastischen Glied entgegenwirkenden Schiebekraft, um den zweiten Schieber aus der vorgerückten Stellung in die eingefahrene Stellung zu bringen. Zur Fixierung der Schieber in der vorgerückten oder eingefahrenen Stellung sind Halterücksprünge vorgesehen, die mit einer Haltenase zusammenwirken.

Aus EP 1 742 315 A1 ist ein Modulgehäuse zum Aufrasten auf einer Tragschiene mit zwei relativ zueinander verschieblichen Verriegelungsschiebern bekannt, die über eine Feder miteinander verbunden sind und jeweils Abschnitte zum Untergreifen von Tragschienenrändern (Rastnasen) aufweisen. Ein mit Hilfe eines Schraubendrehers drehbarer Spreizstift erstreckt sich senkrecht durch beide Verriegelungsschieber hindurch, so dass bei Drehen des Spreizstiftes eine alternative Bewegung der Verriegelungsschieber zueinander zum Öffnen oder Schließen des Rastfußes bewirkt wird.

Weiterhin zeigt EP 0 978 913 B1 eine Klemmvorrichtung als Bestandteil eines auf einer Tragschiene montierbaren Gerätegehäuses mit einer Gehäuseführung zur Aufnahme der Tragschiene. Auf beiden Seiten der Gehäuseführung sind Hal-tenasen vorgesehen, die in einer Schließstellung in die Gehäuseführung derart hineinragen, dass sie die Profilrandung der Tragschiene formschlüssig umgreifen. Mittels eines gemeinsamen Schiebers ist jede Haltenase in einer aus der Geräteführung zurückgezogene Öffnungsstellung verfahrbar, wobei die Hal-tenasen einstückig an dem gemeinsamen Schieber angeformt und elastisch ver-formbar sind. Der Schieber wird in Öffnungsstellung mittels eines Rasthebels an einem Gehäuseanschlag verrastet.

WO 2004/114466 A1 zeigt ein Tragschienengehäuse mit einem Rastfuß zum Auf-setzen auf einer Tragschiene, wobei zwei relativ zueinander bewegliche Rastla-schen mit jeweils mindestens einer Rastnase über ein in Erstreckungsrichtung der Tragschiene drehbar gelagertes Drehkoppelelement miteinander gekoppelt sind, so dass eine Bewegung der einen Rastlasche in eine Bewegung der anderen Rastla-sche umgesetzt wird und die Rastlaschen mit den zugehörigen Rastnasen damit relativ zueinander beweglich sind.

WO 2013/054873 A1 offenbart ein Tragschienengehäuse mit einem Rastfuß, der zwei relativ zueinander bewegliche Rastlaschen mit Rastnasen hat. Die Rastlaschen sind über einen Federarm miteinander gekoppelt, um diese in die Rastpositi-on zu führen. An mindestens einer Rastlasche ist ein Verriegelungsarm vorgese-hen, der mit dem Gehäuse zusammenwirkt, um die Rastlasche in Endstellung der Offenposition und Rastposition zu halten.

Die Betätigung der Rastlasche erfolgt mit einem Kipphebel, der über einen elastisch an der Rastlasche angeformten Kipparm an die Rastlasche angebunden ist. Die über den Kipphebel beaufschlagbare Rastlasche steht im geöffneten Zustand mit Hilfe einer zwischen dem Gerätegehäuse und der Rastlasche wirkenden Druckfe-der (Spiralfeder) unter Vorspannung.

Ausgehend hiervon ist es Aufgabe der vorliegenden Erfindung, ein verbessertes Tragschienengehäuse mit einem Rastfuß zum Aufsetzen auf eine Tragschiene zu schaffen, bei dem die Rastlaschen mit ihren Rastnasen in einer Offenposition, bei der die Rastnasen von der Tragschiene entrastet sind, auf möglichst einfache Weise in der Offenstellung gehalten werden.

Die Aufgabe wird durch das Tragschienengehäuse mit den Merkmalen des Anspruchs 1 gelöst. Vorteilhafte Ausführungsformen sind in den Unteransprüchen beschrieben.

Es wird vorgeschlagen, dass der Rastfuß weiterhin einen Verriegelungsarm mit einem in die Tragschienenaufnahmeöffnung in einer Offenposition, bei der die Rastnasen von der Tragschiene entrastet sind, zur Anlage an einer Seitenkante der in der Tragschienenaufnahmeöffnung aufnehmbaren Tragschiene hineinragenden Anschlag hat. Der Verriegelungsarm steht derart in Wirkverbindung mit den Rastlaschen, dass die Rastlaschen durch die Anlage des Anschlags in der Offenposition gehalten werden.

Durch den zusätzlichen Verriegelungsarm gelingt es auf konstruktiv einfache und platzsparende Weise bei sehr einfacher Handhabung, die Rastlaschen nach Relativbewegung der Rastlaschen in die Offenposition in dieser Offenposition zu fixieren. Hierzu gelangt der Anschlag des Verriegelungsarms in eine Anlage an einer Seitenkante einer in die Tragschienenaufnahmeöffnung aufnehmbaren Tragschiene, so dass die Rastlaschen mit Hilfe dieses Anschlags in der Offenposition lagefixiert werden. Anschließend kann das Tragschienengehäuse dann leicht von der Tragschiene abgenommen werden, ohne dass eine anderweitige zwangsweise Offenhaltung der Rastlaschen erforderlich ist.

Nachdem das Tragschienengehäuse von der Tragschiene abgenommen wurde gelangt der Anschlag des Verriegelungsarms aus dem Eingriff der Tragschiene und gibt die Rastlaschen wieder frei. Für den Fall, dass die Rastlaschen unter Vorspannung z.B. durch ein Federelement stehen, gleiten die Rastlaschen wieder in die Rastposition zurück. Dies ist jedoch nicht mehr nachteilig, da die Offenposition im von der Tragschiene abgenommenen Zustand nicht mehr benötigt wird.

Der Verriegelungsarm ist vorzugsweise elastisch federnd ausgebildet. Dabei ist es besonders vorteilhaft, wenn der Verriegelungsarm integral, d.h. einstückig an einer der Rastlaschen angeformt ist. So kann sich der Verriegelungsarm beispielsweise auf platzsparende Weise neben oder ggf. teilweise oberhalb der zugeordneten Rastlasche erstrecken.

Durch die integrale Ausbildung des Verriegelungsarms mit einer Rastlasche kann der Verriegelungsmechanismus auf einfache und preiswerte Weise zusammen mit der Spritzgussfertigung der Rastlasche ohne zusätzlichen Teilebedarf und ohne zusätzlichen Montageaufwand hergestellt werden.

Besonders vorteilhaft ist es, wenn das Tragschienengehäuse und der Verriegelungsarm aufeinander abgestimmte und aneinander anliegende Führungskonturen haben. Die Führungskonturen sind dabei zur Verlagerung des Anschlags aus einem zwischen einer in der Tragschienenaufnahmeöffnung eingebrachten Tragschiene und dem Boden der Tragschienenaufnahmeöffnung liegenden ersten Bereich in einen zwischen einer Seitenwand der Tragschienenaufnahmeöffnung und einer Seitenkante der Tragschiene liegenden zweiten Bereich ausgebildet, wenn die Rastnasen der beiden Rastlaschen von der Rastposition in die Offenposition voneinander weg bewegt werden.

Damit dient der den Anschlag aufweisende Abschnitt des Verriegelungsarms in der Offenposition durch die Anlage an einer Seitenkante der Tragschiene bei Verlagerung in den zweiten Bereich dazu, den Rastfuß in der Offenposition zu halten. In der verrasteten Position (Raststellung) hingegen wird der den Anschlag aufweisende Bereich des Verriegelungsarms in den ersten Bereich zwischen Tragschienengehäuse und einer Oberseite der Tragschiene verlagert.

Die entsprechende Verlagerung des den Anschlag aufweisenden Endabschnitts des Verriegelungsarms wird durch die Führungskonturen erreicht. Bei Relativbewegung der Rastlaschen zueinander wird der Endabschnitt des Verriegelungsarms somit mit Hilfe der Verriegelungskonturen vom ersten Bereich in den zweiten Bereich hin definiert verlagert und umgekehrt.

In einer weiter bevorzugten Ausführungsform ist das Koppelelement als eine Drehscheibe ausgeführt, die um eine sich in Erstreckungsrichtung einer in der Tragschienenaufnahmeöffnung aufnehmbaren Tragschiene erstreckende Drehachse drehbar gelagert ist. Die Rastlaschen sind dabei mit der zwischenliegenden Drehachse einander gegenüberliegend an der Drehscheibe angelenkt. Bei Verschiebung einer Rastlasche wird somit eine Drehung der daran angelenkten Drehscheibe um die Drehachse bewirkt. Dies führt dazu, dass die andere Rastlasche ebenfalls relativ zur betätigten Rastlasche verlagert wird. Bei dieser Ausführungsform ist es nicht erforderlich, dass die Rastlaschen unmittelbar einander gegenüberliegend, d.h. diametral gegenüberliegend (180° versetzt), an der Drehscheibe angelenkt sind, auch wenn dies besonders vorteilhaft ist. Denkbar ist, dass die Rastlaschen um mehr als 180° versetzt zueinander aber an gegenüberliegenden Seiten relativ zur Drehachse an die Drehachse angebunden sind.

Die Rastlaschen haben vorteilhafterweise jeweils eine bezogen auf die Öffnungsebene der Tragschienenaufnahmeöffnung im spitzen Winkel verlaufende Schrägfläche. Die Öffnungsebene der Tragschienenaufnahmeöffnung ist dabei diejenige Öffnungsebene, durch die eine Tragschiene in die Tragschienenaufnahmeöffnung hinein geführt wird. Mit Hilfe dieser Schrägflächen gelingt es, dass das Tragschienengehäuse auch in der Rastposition der Rastlaschen auf eine Tragschiene aufgesetzt werden kann, ohne dass die Rastlaschen vorher in die Offenstellung verfahren werden müssen. Durch die Schrägflächen wird beim Aufsetzen des Tragschienengehäuses auf die Tragschiene eine Kraft auf die Rastlaschen ausgeübt, die die Rastlaschen relativ zueinander so bewegen, dass die einander gegenüberliegenden Rastnasen in Richtung der Offenposition auseinander getrieben werden. Da hierbei die Offenposition nur soweit erreicht wird, dass die spitzen Enden der Rastnasen soeben an den Seitenkanten der Tragschiene entlang gleiten können, kann der Anschlag des Verriegelungsarms bei einem solchen Aufsetzen nicht automatisch in die Anlage an der Seitenkante der Tragschiene gelangen, um die Rastlaschen beim Aufsetzen in der Offenposition zu halten. Es ist daher nicht erforderlich, dass der Verriegelungsarm in irgendeiner Weise manuell betätigt werden muss. Der Verriegelungsarm wirkt somit nur beim manuellen Öffnen der Rastlaschen von der Rastposition in die Offenposition und dabei auch wiederum ohne die Notwendigkeit einer manuellen Verriegelung des Verriegelungsarms selbst.

Das Tragschienengehäuse hat vorzugsweise mindestens eine Leiterplatte mit Elektronik und mit mindestens einem mit der Leiterplatte elektrisch leitend verbindbaren Steckelement mit Leiteranschlusskontakten zum Anklemmen von elektrischen Leitern. Besonders vorteilhaft ist es, wenn das Tragschienengehäuse ein elektronisches Modulgerät einer modularen Steuerungseinrichtung ist. So kann das Tragschienengehäuse beispielsweise als Feldbuskontroller mit einer Recheneinheit zur Ausführung eines Steuerprogramms, ein Feldbuskoppler oder an solche Feldbuskontroller oder Feldbuskoppler angeschlossene I/O-Module ausgebildet sein. Derartige I/O-Module können Eingangsmodule zur Erfassung von Eingangssignalen, z.B. von Sensoren, Ausgangsmodule zur Ausgabe von Signalen z.B. an angeschlossene Aktoren, Motorsteuerungsmodule, Schnittstellenmodule (z.B. RS232/RS434, USB etc.) oder sonstige Module sein. Dabei ist es vorteilhaft, wenn die Tragschienengehäuse an mindestens einer Seitenkante Steckkontakte haben, um durch Aneinanderreihung von Tragschienengehäusen beim Aufsetzen automatisch einen Datenbus, eine Systemspannungsversorgung und/oder eine elektrische Leistungsversorgung für die angeschlossenen Busteilnehmer zu etablieren.

Die Erfindung wird nachfolgend anhand eines Ausführungsbeispiels mit dem beigefügten Zeichnungen näher erläutert. Es zeigen:
- Figur 1 -: Seiten-Schnittansicht eines Tragschienengehäuses im Bereich des Rastfußes in der Rastposition;
- Figur 2 -: Seiten-Schnittansicht des Tragschienengehäuses aus Figur 1 im Bereich des Rastfußes in der offenen Position;
- Figur 3 -: Perspektivische Ansicht einer ersten Rastlasche des Rastfußes mit daran angeformtem Verriegelungsarm;
- Figur 4 -: Perspektivische Ansicht der zweiten Rastlasche;
- Figur 5 -: Perspektivische Darstellung des als Drehscheibe ausgeführten Koppelelementes;
- Figur 6 -: Perspektivische Ansicht einer U-förmigen Feder zur Kraftbeaufschlagung der ersten Rastlasche;
- Figur 7 -: Seitenansicht der ersten Rastlasche;
- Figur 8 -: Seitenansicht der zweiten Rastlasche;
- Figur 9 -: Seitenansicht des vollständigen Tragschienengehäuses.

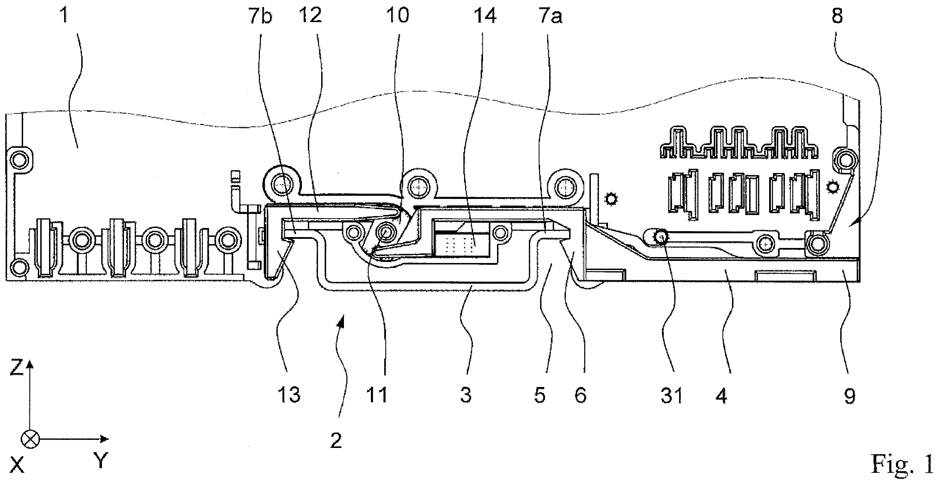

Figur 1 zeigt eine Ausführungsform eines Tragschienengehäuses 1 in der Seitenansicht im Ausschnitt eines Rastfußes 2, mit dem das Tragschienengehäuse 1 auf eine Tragschiene 3 aufgesetzt und verrastet wird. Der Rastfuß 2 hat eine erste Rastlasche 4, die sich von einer ersten Seitenkante (im Bild die rechte Seitenkante) bis in eine Tragschienenaufnahmeöffnung 5 hinein erstreckt. Die erste Rastlasche 4 hat eine Rastnase 6, die ebenfalls in die Tragschienenaufnahmeöffnung 5 hinein weist, um in der dargestellten Rastposition an einer Seitenkante der Tragschiene 3 zu verrasten und einen umgefalteten sich längs erstreckenden Steg 7a der Tragschiene 3 zu untergreifen. An der Seitenwand des Tragschienengehäuses 1, aus der die erste Rastlasche 4 herausragt, ist eine schräg zulaufende Betätigungsöffnung 8 im aus Isolierstoffmaterial gebildeten Tragschienengehäuse 1 vorgesehen. Damit kann ein Betätigungswerkzeug, wie z.B. ein Schraubendreher, in die Betätigungsöffnung 8 eingeführt und in Wirkverbindung mit dem freien Ende 9 der Rastlasche 4 gebracht werden, um die Rastlasche 4 aus der dargestellten Rastposition in eine Offenposition zu verlagern.

An das dem freien Betätigungsende 9 gegenüberliegende freie Ende der Rastlasche 4 ist ein drehbar gelagertes Koppelelement 10 angelenkt. Hierzu greift ein quer von der Rastlasche 4 abgehender Finger in eine korrespondierende Lageröffnung des Koppelelements 10 ein. Das Koppelelement 10 ist als Drehscheibe ausgeführt, die um eine sich in der Erstreckungsrichtung X der Tragschiene 3 erstreckende und am Tragschienengehäuse 1 bzw. dem Rastfuß 2 angeordnete Drehachse 11 gelagert ist.

An das Koppelelement 10 ist eine zweite Rastlasche 12 angelenkt. Dieses ist ebenfalls mit einem sich quer zur zweiten Rastlasche 12 erstreckenden Finger in einer Lageröffnung des Koppelelements 10 gelagert. Die zweite Rastlasche 12 ist L-förmig geformt und hat an ihrem freien Ende ebenfalls eine Rastnase 13 zur Verrastung an der zweiten sich längs in X-Richtung erstreckende Seitenkante 7b der Tragschiene 3.

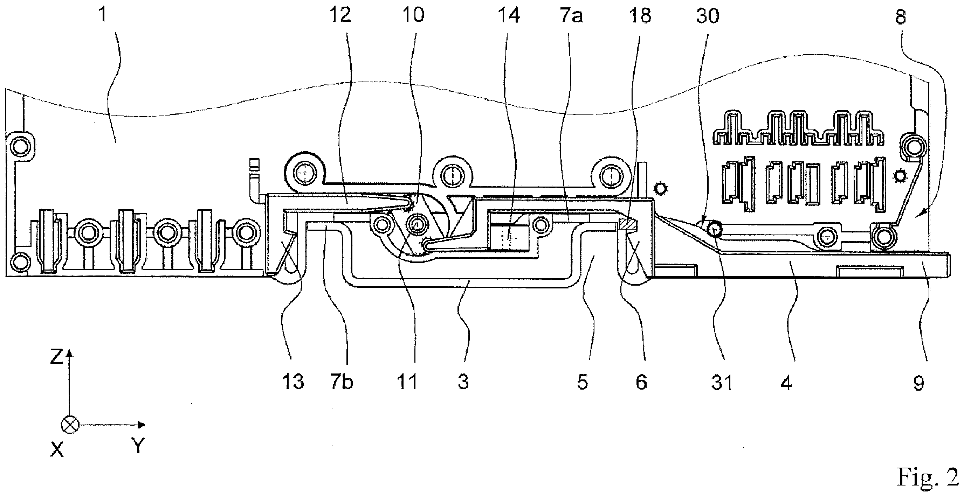

Die erste und zweite Rastlasche 4, 12 erstrecken sich im Wesentlichen parallel zueinander und relativ beweglich zueinander so gelagert, dass die Rastnasen 6, 13 bei einem teilweisen Herausziehen der Rastlasche 4 aus der dargestellten Rastposition in die in der Figur 2 skizzierten Offenposition auf einer gleichbleibenden Ebene voneinander weg bewegt werden.

Aus Figur 2 ist die Offenposition erkennbar, bei der die erste Rastlasche 4 mit ihrem freien Betätigungsende 9 teilweise aus der Seitenwand des Tragschienengehäuses 1 herausragt. Dabei wird eine Drehung des Koppelelementes 10 um die Drehachse 11 bewirkt, welche die zweite Rastlasche 12 mit ihrer Rastnase 13 von der Rastnase 6 der ersten Rastlasche 4 weg bewegt. Hierdurch werden die Rastnasen 6 und 13 so weit voneinander weg bewegt, dass diese aus dem Eingriff von der jeweiligen Seitenkante der Tragschiene 3 bzw. den längs verlaufenden Seitenstegen 7a, 7b gelangen. Damit ist der Rastfuß 2 entrastet und das Tragschienengehäuse 1 kann von der Tragschiene 3 abgenommen werden.

Aus den Figuren 1 und 2 ist weiterhin ein Federelement 14 erkennbar, das zwischen dem aus Isolierstoff gebildeten Tragschienengehäuse 1 und einem L-förmig abgewinkelten Bereich der ersten Rastlasche 4 angeordnet ist. In der Rastposition gemäß Figur 1 ist das Federelement 14 entspannt bzw. die einander gegenüberliegenden Federarme der U-förmig gebogenen Blattfeder sind weiter voneinander weg beabstandet als in der Offenposition gemäß Figur 2. Dort wird das Federelement 14 durch das teilweise Herausziehen der ersten Rastlasche 4 durch Drücken der einander gegenüberliegenden Federarme aufeinander zu gespannt. Dies führt dazu, dass die erste Rastlasche 4 unter der Kraft des Federelementes 14 (Blattfeder) bei Lösen der ersten Rastlasche 4 automatisch in die Rastposition zurückgeführt wird.

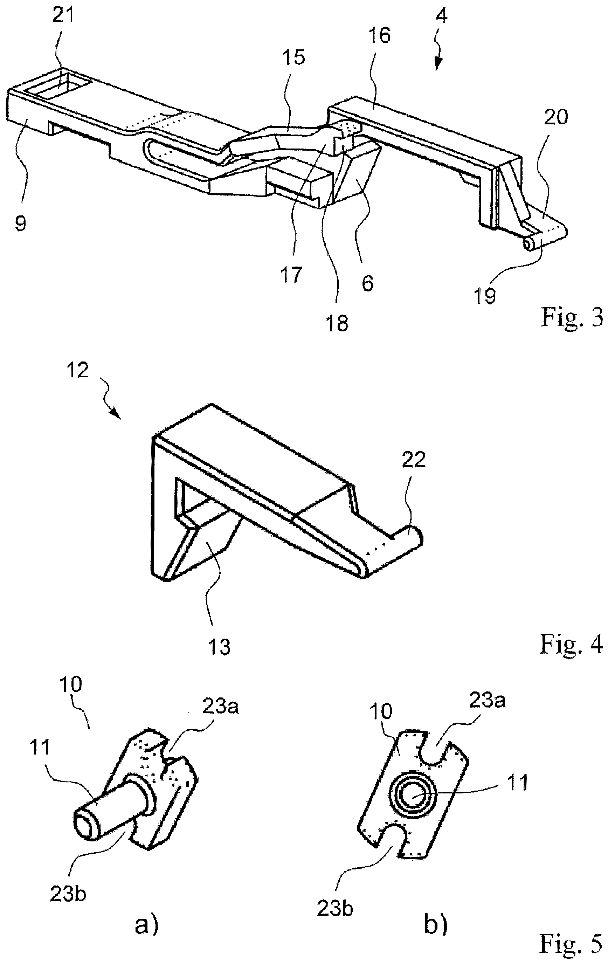

Um nun den Rastfuß 2 automatisch in der Figur 2 dargestellten Offenposition zu halten, hat die erste Rastlasche 4 einen in Figur 3 erkennbaren Verriegelungsarm 15. Dieser Verriegelungsarm 15 erstreckt sich neben dem die Rastnase 6 tragenden Steg 16 der Rastlasche 4 ausgehend von dem ersten Betätigungsende 9 in die zur Rastnase 6 weisende Erstreckungsrichtung hin. Deutlich wird, dass der Verriegelungsarm 15 einstückig, d.h. integral mit der ersten Rastlasche 4 z.B. durch Spritzguss aus einem Kunststoffmaterial ausgeformt und hierdurch elastisch federnd ist. Das freie Ende des Verriegelungsarms 15 hat einen annährend quaderförmigen Kopf 17 mit einer im Querschnitt L-förmigen Ausnehmung zur Bildung eines Anschlags 18. Dieser Anschlag 18 gelangt in Eingriff mit der Seitenkante des ersten Seitensteges 7a einer in der Tragschienenaufnahmeöffnung 5 aufgenommenen Tragschiene 3, wenn die in Figur 2 dargestellte Offenposition erreicht wird. Auf diese Weise wird verhindert, dass die erste Rastlasche 4 und damit auch die über das Koppelelement 10 damit gekoppelte zweite Rastlasche 12 in die Rastposition gemäß Figur 1 zurückfedert, wenn die erste Rastlasche 4 losgelassen wird.

Der Verriegelungsarm 15 hat eine verriegelungsarmseitige Führungskontur in Form einer Schrägfläche 30 an der Oberseite des Verriegelungsarms 15. Das Tragschienengehäuse 1 hat eine zugeordnete gehäuseseitige Führungskontur in Form eines am Tragschienengehäuse 1 fest angeordneten Zapfens 31. Beim teilweisen Herausziehen der ersten Rastlasche 4 liegt die verriegelungsarmseitige Führungskontur (d.h. die Schrägfläche 30) an der gehäuseseitigen Führungskontur (d.h. dem Zapfen 31) an. Der Verriegelungsarm 15 wird durch diese aufeinander abgestimmten Führungskonturen nach unten in Richtung Rastnase 6 und Seitenkante der Tragschiene 3 gedrückt. Nach dem Abziehen des Tragschienengehäuses 1 von der Tragschiene 3 wird diese Verriegelung des Rastfußes 2 durch den Anschlag 18 aufgehoben und die erste und zweite Rastlasche 4, 12 können dann unter Kraft der Blattfeder 14 aufeinander zu gleiten, um in die Rastposition zu gelangen.

In der dargestellten Ausführungsform gleitet der tragschienenseitige feststehende Zapfen 31 auf der Schrägfläche 30 an der Oberseite des Verriegelungsarms 15 und zwingt diesen in eine Auslenkbewegung für die Offenstellung. Eine alternative Ausführungsform ist dahingehend denkbar, dass der Verriegelungsarm 15 während der Aufrastbewegung federelastisch nach oben ausgelenkt und vorgespannt wird, wenn der Kopf 17 auf dem Tragschienenrand zur Anlage kommt. Während der Öffnungsbewegung der Rastlaschen 4, 12 wird der Verriegelungsarm 15 dann bei einer genügend weiten Offenstellung zurückschnappen, so dass der Anschlag 18 zur Anlage kommen kann.

Beim Aufsetzen des Tragschienengehäuses 1 mit dem in Rastposition befindlichen Rastfuß 2 werden die Rastnasen 6, 13 aufgrund ihrer konisch zulaufenden Form mit einer im spitzen Winkel bezogen auf die Öffnungsebene der Tragschienenaufnahmeöffnung 5 bzw. auf die durch die Tragschiene 3 aufgespannten Ebene oder bezogen auf die durch den Boden des Tragschienengehäuses 1 aufgespannten Ebene verlaufenden Schrägfläche voneinander weg bewegt, wenn die Rastnasen 6, 13 an den Seitenkanten der Seitenstege 7a, 7b aufliegen. Eine Betätigung zum Öffnen des Rastfußes 2 in die Offenposition ist beim Aufsetzen des Tragschienengehäuses 1 auf eine Tragschiene 3 nicht erforderlich.

Figur 3 lässt weiter den Finger 19 am freien Anlenkende 20 der ersten Rastlasche 4 erkennen, die dem freien Betätigungsende 9 gegenüberliegt. Dieser Finger 19 ragt quer von dem Steg 16 ab, der sich von dem Rastfuß 6 in Richtung freies Anlenkende 20 erstreckt.

Deutlich wird weiterhin, dass an dem freien Betätigungsende 9 eine Betätigungsöffnung 21 vorhanden ist. In diese Betätigungsöffnung 21 kann ein Schraubendreher oder ein sonstiges geeignetes Betätigungswerkzeug eingeführt werden, um die erste Rastlasche 4 durch eine Hebelkraft unter Auflage des Schraubendrehers am Tragschienengehäuse 1 zu verlagern.

Figur 4 lässt eine perspektivische Ansicht der L-förmigen zweiten Rastlasche 12 erkennen. Deutlich wird, dass an einem freien Ende eine schräg zulaufende Rastnase 13 vorgesehen ist, die sich in Richtung des anderen Endes erstreckt. Die Rastnase 13 ist an dem kurzen Schenkel der L-förmigen Rastlasche 12 angeordnet. Auf einem freien Ende des langen Schenkels ist ebenfalls ein quer abragender Finger 22 vorgesehen, der in eine korrespondierende Lageröffnung des Koppelelementes 10 eingeführt wird.

Figur 5 lässt in der Teilfigur a) eine perspektivische Ansicht und in der Teilfigur b) eine Seitenansicht des Koppelelementes 10 erkennen. Deutlich wird, dass beidseits der Drehachse 11 Lageröffnungen 23a, 23b vorhanden sind. Diese Lageröffnungen 23a, 23b sind in dem dargestellten Ausführungsbeispiel diametral gegenüberliegend. Optional können sie aber auch versetzt zueinander auf einander gegenüberliegenden Seiten der Drehachse 11 sein.

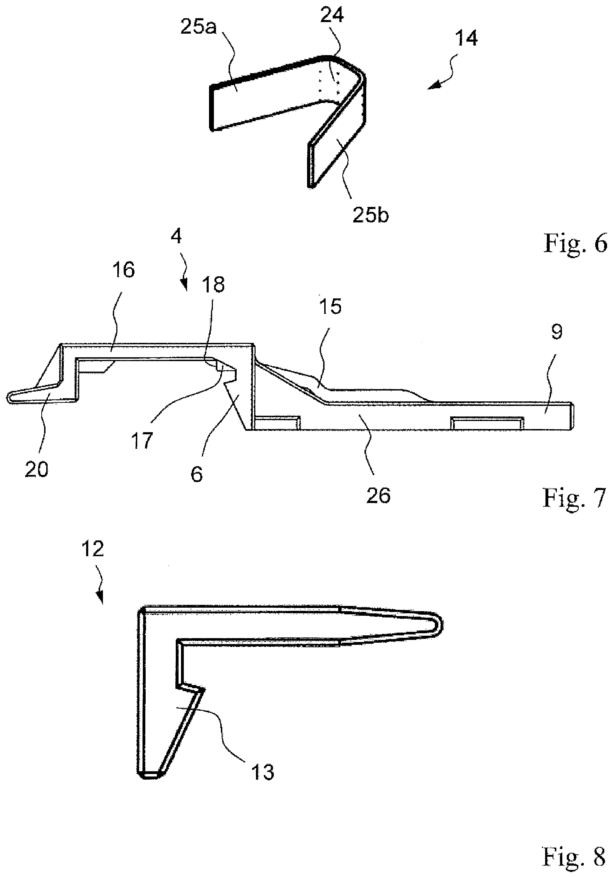

Figur 6 lässt eine perspektivische Ansicht der U-förmig gebogenen Blattfeder 14 erkennen. Deutlich wird, dass die Blattfeder 14 zwei sich von einem gemeinsamen Federbogen 24 erstreckende Federarme 25a, 25b aufweist. Alternativ kann aber auch eine Druckfeder z.B. in Form einer Spiralfeder oder ähnliches vorgesehen sein.

Figur 7 lässt eine Seitenansicht der ersten Rastlasche 4 erkennen. Deutlich wird, dass sich die erste Rastlasche 4 mit einem ersten Steg 26 von dem Betätigungsende 9 erstreckt. An dem Ende des ersten Steges 26 ist die schräg zulaufende Rastlasche 6 vorhanden. Parallel hierzu erstreckt sich der Verriegelungsarm 15 so, dass der Kopf 17 am freien Ende des Verriegelungsarms 15 mit dem Anschlag 18 unterhalb des zweiten Steges 16 liegt. Deutlich wird, dass der Anschlag 18 vom Betätigungsende 9 bis 10 etwas weiter als das spitze Ende der Rastnase 6 herausragt. Damit wird beim Aufsetzen des Tragschienengehäuses 1 auf die Tragschiene 3 verhindert, dass der Anschlag 18 in Eingriff mit der Seitenkante der Tragschiene 3 kommt und den Rastfuß 2 in der Offenposition hält. Erst bei einer Öffnung der ersten Rastlasche 4 in die Offenstellung so weit, dass die Rastnase 6 außer Eingriff mit dem Seitensteg 7a der Tragschiene 3 ist, wird der Anschlag 18 an der Seitenkante des Seitensteges 7a der Tragschiene 3 vorbeigeführt und kann schließlich an der Seitenkante des Seitensteges 7a anliegen, um den Rastfuß 2 in der Offenstellung zu halten.

Deutlich wird weiterhin, dass der zweite Steg 16 wiederum in Richtung des freien Endes L-förmig abgewinkelt ist und mit einer weiteren L-förmigen Abwinkelung zum Anlenkende 20 übergeht.

Figur 8 lässt eine Seitenansicht der L-förmig geformten zweiten Verriegelungslasche 12 erkennen. Hierbei kann im Wesentlichen auf die Beschreibung zu Figur 4 verwiesen werden.

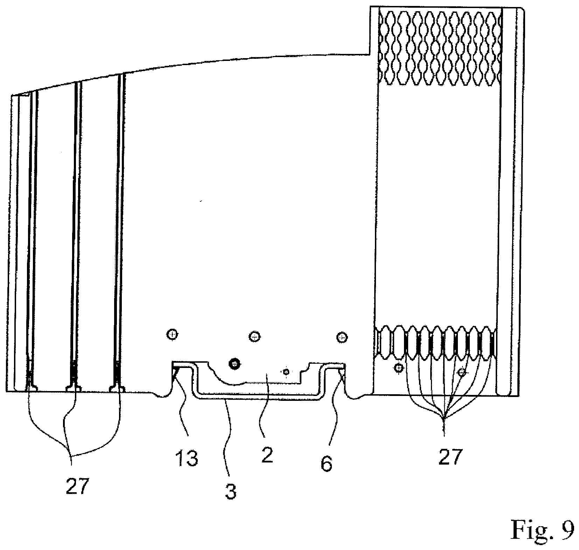

Figur 9 lässt eine Seitenansicht des Tragschienengehäuses 1 erkennen, das in der dargestellten Ausführungsform als einstückiges Isolierstoffgehäuse mit daran integriertem Rastfuß 2 ausgebildet ist. Alternativ hierzu kann auch ein mehrteiliges Isolierstoffgehäuse mit einem den Rastfuß 2 aufweisenden Basisteil, einem darauf aufsetzbaren Elektronikmodul und einem auf das Elektronikmodul aufsetzbaren Steckverbindermodul mit Steckkontakten zum Anschließen von elektrischen Leitern vorgesehen sein. Deutlich wird, dass an den Seitenflächen des Tragschienengehäuses 1 eine Anzahl von Steckkontakten 27 vorhanden sind. Mit Hilfe der rechts im Bild dargestellten Steckkontakte 27 kann beim Aneinanderreihen einer Mehrzahl von Tragschienengehäusen 1 auf eine Tragschiene 3 ein Datenbus und eine Systemspannungsversorgung etabliert werden. Mit Hilfe der auf der linken Seite dargestellten Steckkontakte 27 kann eine Leistungsversorgung für an die Tragschienengehäuse 1 bzw. an die hiermit gebildeten elektrischen Geräte angeschlossenen Busteilnehmer wie beispielsweise Aktoren, Sensoren oder ähnliches bereitgestellt werden. Dabei ist es nicht erforderlich, dass die hierdurch geschleifte Leistungsversorgung auch von jedem Tragschienengehäuse 1 genutzt wird.

## Patentansprüche

1. Tragschienengehäuse (1) mit einem Rastfuß (2) zum Aufsetzen auf eine Tragschiene (3), wobei der Rastfuß (2)
- eine Tragschienenaufnahmeöffnung (5) zur Aufnahme einer Tragschiene (3),
- zwei relativ zueinander bewegliche Rastlaschen (4, 12) mit jeweils mindestens einer Rastnase (6, 13), die in einer Rastposition in die Tragschienenaufnahmeöffnung (5) zur Verrastung mit einer in der Tragschienenaufnahmeöffnung (5) aufnehmbaren Tragschiene (3) hinein ragen, und
- ein Koppelelement (10) hat, das in Wirkverbindung mit den beiden Rastlaschen (4, 12) steht und eine Bewegung einer Rastlasche (4) in eine Bewegung der anderen Rastlasche (12) überträgt, **dadurch gekennzeichnet, dass** der Rastfuß (2) weiterhin einen Verriegelungsarm (15) mit einem in die Tragschienenaufnahmeöffnung (5) in einer Offenposition, bei der die Rastnasen (6, 13) von der Tragschiene (3) entrastet sind, zur Anlage an einer Seitenkante der in der Tragschienenaufnahmeöffnung (5) aufnehmbaren Tragschiene (3) hinein ragenden Anschlag (18) hat, wobei der Verriegelungsarm (15) derart in Wirkverbindung mit den Rastlaschen (4, 12) steht, dass die Rastlaschen (4, 12) durch die Anlage des Anschlages (18) in der Offenposition gehalten werden.

2. Tragschienengehäuse (1) nach Anspruch 1, **dadurch gekennzeichnet, dass** der Verriegelungsarm (15) integral mit einer der Rastlaschen (4, 12) geformt ist.

3. Tragschienengehäuse (1) nach Anspruch 1 oder 2, **dadurch gekennzeichnet, dass** der Verriegelungsarm (15) elastisch federnd ist.

4. Tragschienengehäuse (1) nach einem der vorhergehenden Ansprüche, **dadurch gekennzeichnet, dass** ein Federelement (14) in Wirkverbindung zwischen dem Tragschienengehäuse (1) und mindestens einer der Rastlaschen (4, 12) steht, um die Rastlaschen (4, 12) unter Federkraft des Federelementes (14) aus einer Offenposition in Richtung Rastposition zurückzuführen.

5. Tragschienengehäuse (1) nach einem der vorhergehenden Ansprüche, **dadurch gekennzeichnet, dass** das Tragschienengehäuse (1) und der Verriegelungsarm (15) aufeinander abgestimmte und aneinander anliegende Führungskonturen haben, wobei die Führungskonturen zur Verlagerung des Anschlages (18) aus einem zwischen einer in der Tragschienenaufnahmeöffnung (5) eingebrachten Tragschiene (3) und dem Boden der Tragschienenaufnahmeöffnung (5) liegenden ersten Bereich in einen zwischen einer Seitenwand der Tragschienenaufnahmeöffnung (5) und einer Seitenkante der Tragschiene (3) liegenden zweiten Bereich ausgebildet ist, wenn die Rastnasen (6, 13) der beiden Rastlaschen (4, 12) von der Rastposition in die Offenposition voneinander weg bewegt werden.

6. Tragschienengehäuse (1) nach einem der vorhergehenden Ansprüche, **dadurch gekennzeichnet, dass** der Anschlag (18) des Verriegelungsarms (15) an einem in der Rastposition zwischen Tragschiene (3) und Boden der Tragschienenaufnahmeöffnung (5) positionierbaren Auflager (17) angeordnet ist.

7. Tragschienengehäuse (1) nach einem der vorhergehenden Ansprüche, **dadurch gekennzeichnet, dass** das Koppelelement (10) eine Drehscheibe ist, die um eine sich in Erstreckungsrichtung einer in der Tragschienenaufnahmeöffnung (5) aufnehmbaren Tragschiene (3) erstreckende Drehachse (11) drehbar gelagert ist, wobei die Rastlaschen (4, 12) mit der zwischenliegenden Drehachse (11) einander gegenüberliegend an der Drehscheibe (10) angelenkt sind.

8. Tragschienengehäuse (1) nach Anspruch 7, **dadurch gekennzeichnet, dass** die Rastlaschen (4, 12) diametral gegenüberliegend an der Drehscheibe (10) angelenkt sind.

9. Tragschienengehäuse (1) nach einem der vorhergehenden Ansprüche, **dadurch gekennzeichnet, dass** die Rastnasen (6, 13) jeweils eine bezogen auf die Öffnungsebene der Tragschienenaufnahmeöffnung (5) im spitzen Winkel verlaufende Schrägfläche haben.

10. Tragschienengehäuse (1) nach einem der vorhergehenden Ansprüche mit mindestens einer Leiterplatte und Elektronik und mit mindestens einem mit der Leiterplatte elektrisch leitend verbindbaren Steckelement mit Leiteranschlusskontakten zum Anklemmen von elektrischen Leitern.

11. Tragschienengehäuse (1) nach Anspruch 10, **dadurch gekennzeichnet, dass** das Tragschienengehäuse (1) ein Gerätemodul einer modularen Steuerungseinrichtung ist, insbesondere ein Eingabemodul, ein Ausgabemodul, ein Motorsteuerungsmodul, ein Schnittstellenmodul, ein Feldbuskoppler oder ein Feldbuskontroller mit einer Recheneinheit zur Ausführung eines Steuerungsprogramms.

## Claims

1. A carrier rail housing (1) having a latching base (2) for attaching to a carrier rail (3), wherein the latching base (2) comprises
- a carrier rail receiving opening (5) for receiving a carrier rail (3),
- two latching links (4, 12) that can move relative to one another having in each case at least one latching lug (6, 13) that protrudes in a latched position into the carrier rail receiving opening (5) so as to latch with a carrier rail (3) that can be received in the carrier rail receiving opening (5), and
- a coupling element (10) that is operatively connected to the two latching links (4, 12) and a movement of one latching link (4) is transferred into a movement of the other latching link (12), **characterized in that** the latching base (2) furthermore comprises a locking arm (15) having a stop (18) that protrudes into the carrier rail opening (5) in an open position, in which the latching lugs (6, 13) are unlatched from the carrier rail (3), so as to make contact with a side edge of the carrier rail (3) that can be received in the carrier rail receiving opening (5), wherein the locking arm (15) is operatively connected to the latching links (4, 12) in such a manner that the latching links (4, 12) are held in the open position by means of the stop (18) making contact.

2. The carrier rail housing (1) as claimed in claim 1, **characterized in that** the locking arm (15) is formed with one of the latching links (4, 12) in an integral manner.

3. The carrier rail housing (1) as claimed in claim 1 or 2, **characterized in that** the locking arm (15) is elastically resilient.

4. The carrier rail housing (1) as claimed in any one of the preceding claims, **characterized in that** a resilient element (14) is operatively connected between the carrier rail housing (1) and at least one of the latching links (4, 12) in order to return the latching links (4, 12) under resilient force of the resilient element (14) from an open position in the direction towards the latched position.

5. The carrier rail housing (1) as claimed in any one of the preceding claims, **characterized in that** the carrier rail housing (1) and the locking arm (15) comprise guiding contours that are coordinated with one another and lie one on top of the other, wherein the guiding contours are embodied so as to displace the stop (18) from a first region that lies between a carrier rail (3) that is introduced into a carrier rail receiving opening (5), and the base of the carrier rail receiving opening (5) into a second region that lies between a side wall of the carrier rail receiving opening (5) and a side edge of the carrier rail (3) if the latching lugs (6, 13) of the two latching links (4, 12) are moved away from one another from the latched position into the open position.

6. The carrier rail housing (1) as claimed in any one of the preceding claims, **characterized in that** the stop (18) of the locking arm (15) is arranged on a support (17) that can be positioned in the latched position between the carrier rail (3) and the base of the carrier rail receiving opening (5).

7. The carrier rail housing (1) as claimed in any one of the preceding claims, **characterized in that** the coupling element (10) is a rotating disc that is mounted in such a manner that it can rotate about a rotary shaft (11) that extends in the direction of extension of a carrier rail (3) that can be received in the carrier receiving opening (5), wherein the latching links (4, 12) are connected in an articulated manner to one another lying on opposite sides of the rotating disc (10) with the rotary shaft (11) that lies between said latching links.

8. The carrier rail housing (1) as claimed in claim 7, **characterized in that** the latching links (4, 12) are connected in an articulated manner to the rotating disc (10) and lie diametrically opposite one another.

9. The carrier housing (1) as claimed in any one of the preceding claims, **characterized in that** the latching lugs (6, 13) in each case have an inclined surface that extends at an acute angle with respect to the opening plane of the carrier rail receiving opening (5) .

10. The carrier rail housing (1) as claimed in any one of the preceding claims having at least one circuit board and electronics system and having at least one plug element having conductor connecting contacts for connecting electrical conductors and said plug element can be connected in an electrically conductive manner to the circuit board.

11. The carrier rail housing (1) as claimed in claim 10, **characterized in that** the carrier rail housing (1) is a device module of a modular control device, in particular an input module, an output module, a motor control module, an interface module, a field bus coupler or field bus controller having a computer unit for implementing a control program.

## Revendications

1. Boîtier de rail porteur (1) avec un pied d'encliquetage (2) à poser sur un rail porteur (3), dans lequel le pied d'encliquetage (2) comporte
- une ouverture de réception de rail porteur (5) destinée à recevoir un rail porteur (3),
- deux pattes d'encliquetage mobiles l'une par rapport à l'autre (4, 12) avec chacune au moins un ergot d'encliquetage (6, 13), qui s'engagent dans une position d'encliquetage dans l'ouverture de réception de rail porteur (5) pour l'encliquetage avec un rail porteur (3) pouvant être logé dans l'ouverture de réception de rail porteur (5), et
- un élément de couplage (10), qui est en liaison active avec les deux pattes d'encliquetage (4, 12) et qui transmet un mouvement d'une patte d'encliquetage (4) en entraînant un mouvement de l'autre patte d'encliquetage (12),
**caractérisé en ce que** le pied d'encliquetage (2) comporte en outre un bras de verrouillage (15) avec une butée (18) pénétrant dans l'ouverture de réception de rail porteur (5) dans une position ouverte, dans laquelle les ergots d'encliquetage (6, 13) sont décrochés du rail porteur (3), en vue de l'appui sur un bord latéral du rail porteur (3) pouvant être logé dans l'ouverture de réception de rail porteur (5), dans lequel le bras de verrouillage (15) est en liaison active avec les pattes d'encliquetage (4, 12), de telle manière que les pattes d'encliquetage (4, 12) soient maintenues dans la position ouverte par l'appui de la butée (18).

2. Boîtier de rail porteur (1) selon la revendication 1, **caractérisé en ce que** le bras de verrouillage (15) est formé intégralement avec une des pattes d'encliquetage (4, 12).

3. Boîtier de rail porteur (1) selon la revendication 1 ou 2, **caractérisé en ce que** le bras de verrouillage (15) est élastiquement amorti.

4. Boîtier de rail porteur (1) selon l'une quelconque des revendications précédentes, **caractérisé en ce qu'**un élément de ressort (14) est en liaison active entre le boîtier de rail porteur (1) et au moins une des pattes d'encliquetage (4, 12), afin de ramener les pattes d'encliquetage (4, 12) d'une position ouverte en direction d'une position d'encliquetage sous l'action de la force élastique de l'élément de ressort (14).

5. Boîtier de rail porteur (1) selon l'une quelconque des revendications précédentes, **caractérisé en ce que** le boîtier de rail porteur (1) et le bras de verrouillage (15) présentent des contours de guidage accordés l'un à l'autre et appliqués l'un sur l'autre, dans lequel les contours de guidage sont configurés pour le déplacement de la butée (18) depuis une première région située entre un rail porteur (3) introduit dans l'ouverture de réception de rail porteur (5) et le fond de l'ouverture de réception de rail porteur (5) jusqu'à une deuxième région située entre une paroi latérale de l'ouverture de réception de rail porteur (5) et un bord latéral du rail porteur (3), lorsque les ergots d'encliquetage (6, 13) des deux pattes d'encliquetage (4, 12) sont écartés l'un de l'autre de la position d'encliquetage à la position ouverte.

6. Boîtier de rail porteur (1) selon l'une quelconque des revendications précédentes, **caractérisé en ce que** la butée (18) du bras de verrouillage (15) est disposée sur un support (17) pouvant être positionné dans la position d'encliquetage entre le rail porteur (3) et le fond de l'ouverture de réception de rail porteur (5).

7. Boîtier de rail porteur (1) selon l'une quelconque des revendications précédentes, **caractérisé en ce que** l'élément de couplage (10) est un disque tournant, qui est monté de façon rotative autour d'un axe de rotation (11) s'étendant dans la direction d'extension d'un rail porteur (3) pouvant être logé dans l'ouverture de réception de rail porteur (5), dans lequel les pattes d'encliquetage (4, 12) sont articulées sur le disque tournant (10) l'une en face de l'autre avec l'axe de rotation interposé (11).

8. Boîtier de rail porteur (1) selon la revendication 7, **caractérisé en ce que** les pattes d'encliquetage (4, 12) sont articulées dans des positions diamétralement opposées sur le disque tournant (10).

9. Boîtier de rail porteur (1) selon l'une quelconque des revendications précédentes, **caractérisé en ce que** les ergots d'encliquetage (6, 13) ont chacun une face oblique orientée sous un angle aigu par rapport au plan de l'ouverture de l'ouverture de réception de rail porteur (5) .

10. Boîtier de rail porteur (1) selon l'une quelconque des revendications précédentes avec au moins une plaquette de circuits imprimés et une électronique et avec au moins un élément à fiche pouvant être connecté de façon électriquement conductrice à la plaquette de circuits imprimés, avec des contacts de connexion des circuits imprimés pour le raccordement de conducteurs électriques.

11. Boîtier de rail porteur (1) selon la revendication 10, **caractérisé en ce que** le boîtier de rail porteur (1) est un module d'appareil d'un dispositif de commande modulaire, en particulier un module d'entrée, un module de sortie, un module de commande de moteur, un module d'interface, un coupleur de bus de terrain ou un contrôleur de bus de terrain avec une unité de calcul pour l'exécution d'un programme de commande.
